# EUROPÄISCHE PATENTSCHRIFT

(11) **EP 2 592 525 B1**
(45) Veröffentlichungstag und Bekanntmachung des Hinweises auf die Patenterteilung: **11.07.2018**
(21) Anmeldenummer: 12191977.3
(22) Anmeldetag: 09.11.2012
(51) Int. Cl.: G06F 1/16, H04N 5/64

(54) **Monitor sowie Gehäuserückwand für einen Monitor**
Monitor and back panel for monitor
Moniteur ainsi que couvercle pour un moniteur

(30) Priorität: 11.11.2011 DE 102011086196
(43) Veröffentlichungstag der Anmeldung: 15.05.2013
(73) Patentinhaber: MEKRA Lang GmbH & Co. KG, 90765 Fürth (DE)
(72) Erfinder: Lang, Werner Dr., 91465 Ergersheim (DE); Deffner, Simon, 91604 Flachslanden (DE); Hohenhaus, Jon, 91413 Neustadt an der Aisch (DE); Redlingshöfer, Andreas, 90619 Trautskirchen (DE); Stürzenhofecker, Jens, 91459 Markt Erlbach (DE)
(74) Vertreter: Winter, Brandl, Fürniss, Hübner, Röss, Kaiser, Polte - Partnerschaft mbB

(56) Entgegenhaltungen:
- EP-A1- 1 619 539
- US-A- 5 978 223
- US-A1- 2002 080 297
- US-A1- 2002 109 969
- US-A1- 2004 004 680
- US-A1- 2008 297 600
- US-A1- 2008 297 998
- US-B1- 7 072 179
- US-B1- 7 440 276

## Beschreibung

Die Erfindung betrifft einen Monitor zur Anzeige von optischen Informationen nach dem Oberbegriff des Anspruchs 1 sowie eine Monitorgehäuserückwand für einen Monitor nach Anspruch 16.

In Kraftfahrzeugen werden immer mehr Monitore zur Anzeige von Bildern von Kameras und sonstigen optischen Informationen benötigt. Derartige Monitore müssen aufgrund der in Kraftfahrzeugen auftretenden Vibrationen und des Einsatzes auch im Außenbereich vergleichsweise robust sein und dürfen dennoch nicht zu teuer werden.

Aus US 2002/0080297 A1 ist ein Monitor gemäß dem Oberbegriff des Anspruchs 1 bekannt, der eine Rückwand aus Kunststoff mit Lüftungsschlitzen aufweist. Aus der US 2008/0297600 A1, US 7,440,276 B1, US 7,072,179 B1 und US 2002/0109969 A1 sind Monitore bekannt, die Rückwände aus Metall mit Kühlrippen aufweisen. Aus US 2008/0297998 A1 und US 2004/0004680 A1 sind Monitore bekannt, die mittels Dichtungen spritzwasserdicht sind. Aus US 5,978,223 B ist eine Wärme leitende Schicht bekannt, mittels der Wärme aus einem Elektronikmodul an einen Kühlkörper geleitet wird. Aus EP 1 619 539 A1 ist ein Monitor bekannt, der eine Rückwand aus Metall mit Kühlrippen aufweist, auf die seitlich Abdeckungen aus Plastik geschraubt werden.

Es ist daher Aufgabe der Erfindung einen insbesondere für Kraftfahrzeuge geeigneten Monitor anzugeben, der einen einfachen und kostengünstigen Aufbau aufweist und möglichst wartungsarm ist.

Die Lösung dieser Aufgabe erfolgt durch die Merkmale des Anspruchs 1.

Durch die formschlüssige Verbindung von Anzeigepanel und Ansteuerelektronik mit dem Modulträger einerseits und der formschlüssigen Verbindung des Modulträgers mit Anzeigepanel und Ansteuerelektronik mit dem Frontgehäuserahmen andererseits ist das Funktionsbauteil mit Anzeigepanel und Ansteuerelektronik auf einfache Weise in zwei Dimensionen lagefixiert. Das Funktionsbauteil bzw. der Modulträger mit Anzeigepanel und Ansteuerelektronik werden zwischen Frontgehäuserahmen und Gehäuserückwand eingeklemmt und der Frontgehäuserahmen wird mit der Gehäuserückwand verschraubt, so dass das Funktionsbauteil mit Anzeigepanel und Ansteuerelektronik in der dritten Dimension lagefixiert ist. Die Komponenten im Inneren des Monitorgehäuses sind damit nur durch Formschluss und mittels Press- oder Klemmsitz fixiert. Die Zahl der Schraubverbindungen die sich durch Vibrationen lösen könnten ist dadurch minimiert. Gleichzeitig vereinfacht sich dadurch der Zusammenbau des Monitors, da dessen Komponenten nur zusammengesteckt werden und lediglich die beiden Teile des Monitorgehäuses, Frontgehäuserahmen und Gehäuserückwand, miteinander verschraubt werden. Durch die die Integration eines Kühlkörpers aus Metall in die Gehäuserückwand aus Kunststoff wird die Abwärme des Funktionsbauteils nach außen abgeführt. Durch das Einklemmen von Anzeigepanel und Ansteuerelektronik zwischen Frontgehäuserahmen und Gehäuserückwand wird der thermische Kontakt zwischen Funktionsbauteil und Kühlkörper hergestellt und gleichzeitig wird das Funktionsbauteil im Monitorgehäuse festgeklemmt. Durch die Kühlrippen im Kühlkörper aus Metall wird die Wärmeabfuhr verbessert. Durch das Formen des Gehäuserückwandrahmens um den Kühlkörper mittels Spritzguss werden der Gehäuserückwandrahmen und der Kühlkörper spritzwasserdicht miteinander verbunden.

Durch die vorteilhafte Ausgestaltung der Erfindung nach Anspruch 2 kann der Monitor in üblicher Weise bedient werden.

Die vorteilhafte Ausgestaltung nach Anspruch 3 und 4 stellt eine wartungsfreundliche Ausführungsform dar.

Durch die vorteilhafte Ausgestaltung der Erfindung nach Anspruch 5 wird die Ansteuerelektronik vor Umwelteinflüssen und insbesondere vor Spritzwasser und Feuchtigkeit geschützt. Zusätzlich bietet die verformbare umlaufende Dichtung einen Ausgleich für Fertigungstoleranzen.

Durch die vorteilhafte Ausgestaltung der Erfindung nach Anspruch 6 drückt der Frontgehäuserahmen gegen das Anzeigepanel und die Gehäuserückwand gegen das Funktionsbauteil wodurch Anzeigepanel und Anzeigeelektronik im Modulträger festgeklemmt werden.

Durch die vorteilhafte Ausgestaltung der Erfindung nach Anspruch 8 wird zum einen die Wärmeableitung nach außen verbessert und gleichzeitig gleicht die verformbare Wärme leitende Schicht unvermeidliche Fertigungstoleranzen der einzelnen Komponenten des Monitors aus.

Durch die vorteilhafte Ausgestaltung der Erfindung nach Anspruch 9 werden freistehende scharfe Kanten der Kühlrippen vermieden und gleichzeitig wird an den Enden der Kühlrippen durch die fortgesetzten Kühlkanäle ein Wärmestau vermieden.

Da der Kühlkörper aus Metall und das übrige Monitorgehäuse mit Gehäuserückwandrahmen und Frontgehäuserahmen aus Kunststoff besteht, ist es vorteilhaft die Befestigungsmittel - z. B. Schraublöcher und/oder Längsnute - in dem stabileren Kühlkörper aus Metall vorzusehen - Ansprüche 11 bis 14 bzw. 20.

Die Gehäuserückwand nach Anspruch 15 ist insbesondere aber nicht nur für Monitore gemäß der vorliegenden Erfindung geeignet. Durch die Integration des Kühlkörpers in die Gehäuserückwand wird auf einfache Weise eine effiziente Ableitung der Abwärme aus dem Inneren des Monitorgehäuses erreicht und gleichzeitig wird auf einfache Weise ein gegenüber Spritzwasser dichtes Monitorgehäuse bereitgestellt.

Weitere Einzelheiten, Merkmale und Vorteile der Erfindung ergeben sich aus der nachfolgenden Beschreibung einer beispielhaften Ausführungsform der Erfindung.

Es zeigt:

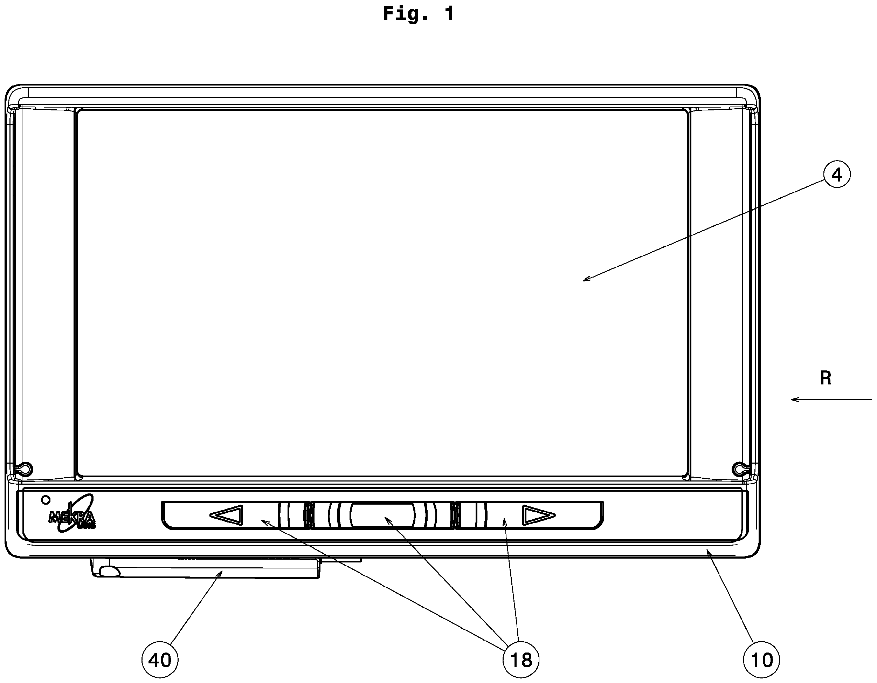

- Fig. 1: eine Frontansicht der beispielhaften Ausführungsform,
- Fig. 2: eine Seitenansichtung aus Richtung des Pfeils R in Fig. 1,

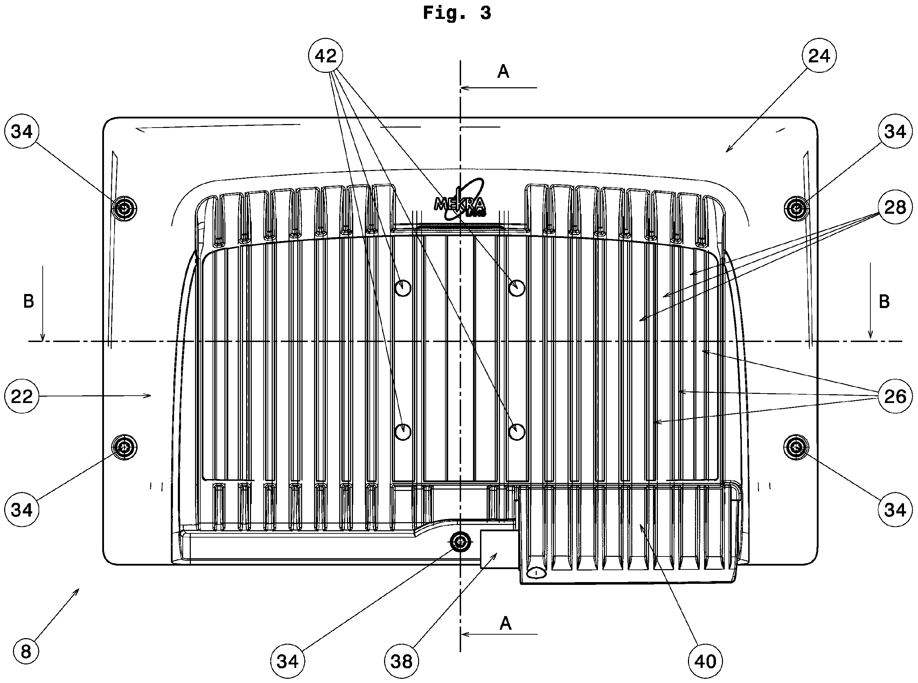

- Fig. 3: eine Rückansicht,
- Fig. 4: eine Schnittansicht entlang der Linie A-A in Fig. 3,
- Fig. 5: eine Schnittansicht entlang der Linie B-B in Fig. 3, und
- Fig. 6: eine perspektivische Rückansicht der beispielhaften Ausführungsform.

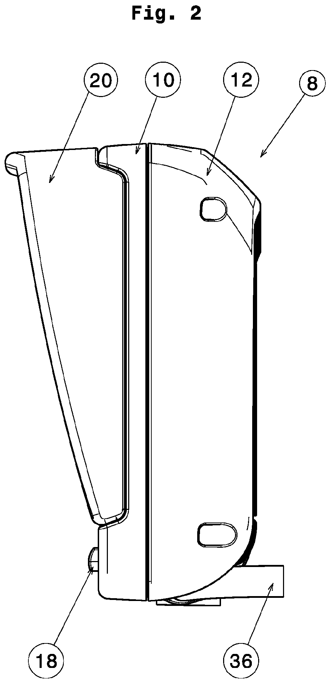

Der modular aufgebaute Monitor gemäß der beispielhaften Ausführungsform umfasst ein Funktionsbauteil 2 mit darin integriertem Anzeigepanel 4 und zugehöriger Ansteuerelektronik 6. Bei dem Anzeigepanel 4 handelt es sich um eine Flüssigkristallanzeige dessen Sichtfeld mit einer Schutzscheibe - nicht dargestellt - versehen ist. Das Funktionsbauteil 2 mit Anzeigepanel 4 und Ansteuerelektronik 6 ist in einem Monitorgehäuse 8 angeordnet, dass aus einem Frontgehäuserahmen 10 und einer Gehäuserückwand 12 besteht. Das Funktionsbauteil 2 umfasst einen Modulträger 14, in dem von einer Seite - der Vorderseite - das Anzeigepanel 4 formschlüssig eingefügt bzw. eingeschoben und damit in zwei Dimensionen lagefixiert ist. Von der anderen Seite - der Rückseite - des Modulträgers 14 wird die zugehörige Ansteuerelektronik 6 formschlüssig eingefügt bzw. eingeschoben und damit in zwei Dimensionen lagefixiert. Die elektrische Verbindung zwischen Ansteuerelektronik 6 und Anzeigepanel 4 erfolgt über nicht näher dargestellte elektrische Kontakte und Leitungen in dem Modulträger 14 bzw. an der Außenseite von Anzeigepanel 4 und Ansteuerelektronik 6. Der Modulträger 14 mit Anzeigepanel 4 und Ansteuerelektronik 6 wird wiederum formschlüssig in dem Frontgehäuserahmen 10 eingeschoben und somit in zwei Dimensionen lagefixiert. Zwischen dem Frontgehäuserahmen 10 und dem Anzeigepanel 4 ist eine umlaufende Dichtung 16 angeordnet, so dass das Anzeigepanel spritzwasserdicht in dem Monitorgehäuse 8 angeordnet ist. Von der Vorderseite des Frontgehäuserahmens 10 her sind Bedienelemente 18 z. B. mittels einer Klebeschicht (nicht dargestellt) auf der Rückseite der Bedienelemente in den Frontgehäuserahmen 10 integriert bzw. eingeklebt. Die elektrische Verbindung mit dem Anzeigepanel 4 bzw. der Ansteuerelektronik 6 erfolgt ebenfalls über nicht dargestellte elektrische Kontakte und Kontaktflächen. Wie aus Fig. 2 zu ersehen ist, ist auf der Vorderseite des Frontgehäuserahmens 10 noch eine Sonnenblende 20 angeordnet um die Ablesbarkeit des Monitors bei Sonnenschein zu verbessern.

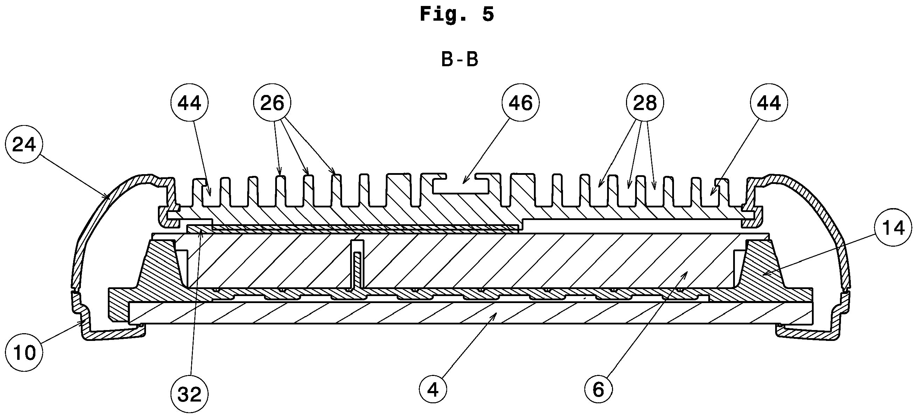

In die Gehäuserückwand 12 ist ein Kühlkörper 22 integriert, so dass die Gehäuserückwand 12 aus dem Kühlkörper 22 und einem Gehäuserückwandrahmen 24 besteht. Hierbei ist der Gehäuserückwandrahmen aus Kunststoff mittels Spritzguss um den Kühlkörper 22 aus Metall geformt, so dass sich die spritzwasserdichte Gehäuserückwand 12 ergibt. Der in die Gehäuserückwand 12 integrierte Kühlkörper 22 weist auf seiner Rück- bzw. Außenseite Kühlrippen 26 auf zwischen denen Kühlkanäle 28 ausgebildet sind. Auf der Innenseite des Kühlkörpers 22 ist eine thermische Kontaktfläche 30 ausgebildet, die in Wärme leitenden Kontakt mit der Ansteuerelektronik 6 steht. Zwischen der thermischen Kontaktfläche 30 und der Ansteuerelektronik 6 ist eine verformbare Wärme leitende Schicht 32 angeordnet, die den Wärmeübergang zwischen Wärme abgebender Ansteuerelektronik 6 und dem Wärme aufnehmenden Kühlkörper 22 verbessert. Wie aus der Schnittdarstellung in Fig. 5 zu ersehen ist, erstreckt sich die thermische Kontaktfläche 30 und die Wärme leitende Schicht 32 nur über einen Teil der Fläche der Ansteuerelektronik 6.

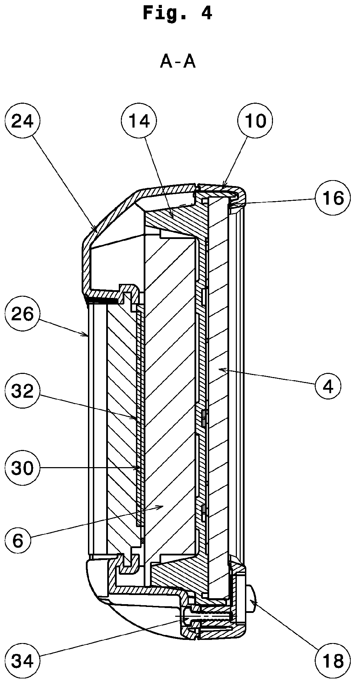

Wie aus den Schnittdarstellungen in Fig. 4 und 5 zu ersehen ist, stützt sich das Anzeigepanel 4 unmittelbar in den Frontgehäuserahmen 10 mit der umlaufenden Dichtung 16 dazwischen ab, während sich die Ansteuerelektronik 6 an der thermischen Kontaktfläche 30 des Kühlkörpers 22 und damit der Gehäuserückwand 12 abstützt. Auf diese Weise wird das Funktionsbauteil 2 mit Ansteuerelektronik 6 und Anzeigepanel 4 zwischen dem Frontgehäuserahmen 10 und der Gehäuserückwand 12 eingeklemmt und in der dritten Dimension bezüglich des Monitorgehäuses 8 lagefixiert. Die Gehäuserückwand 12 ist mittels fünf Schrauben 34 mit dem Frontgehäuserahmen 10 spritzwasserdicht verschraubt.

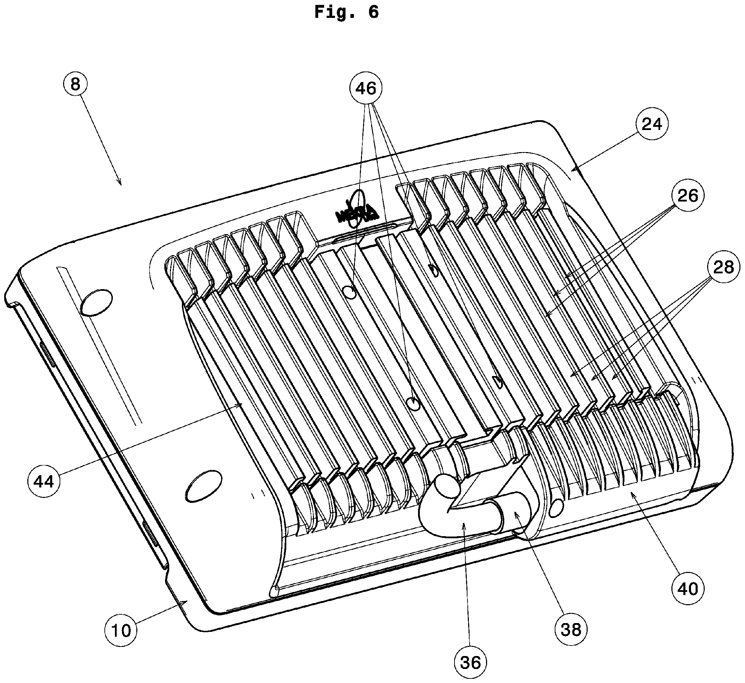

Die Kühlrippen 26 und damit die Kühlkanäle 28 auf der Außenseite der Gehäuserückwand 12 verlaufen vertikal, wodurch die Konvektion und Ableitung der Abwärme gefördert wird. Wie insbesondere aus Fig. 6 zu ersehen, ist sind die Kühlrippen 26 bzw. die Kühlkanäle 28 oben und unten in dem Gehäuserückwandrahmen 24 als Stege 26' und Kühlkanalenden 28' fortgesetzt. Da die Stege 26' die gleiche Höhe wie die Kühlrippen 26 aufweisen, sind die scharfkantigen Enden der Kühlrippen 26 durch die Stege 26' abgedeckt, so dass die Verletzungsgefahr verringert ist. Gleichzeitig setzen sich die Kühlkanäle 28 unten und oben in den Kühlkanalenden 28' fort, wodurch ein insbesondere im oberen Bereich des Gehäuserückwandrahmens 24 bzw. am oberen Ende der Kühlrippen 26 ein Wärmestau verhindert wird, da in den fortgesetzten Kühlkanälen 28' die durch die Abwärme erwärmte Luft leichter abziehen kann. Zu diesem Zweck sind im oberen Bereich des Gehäuserückwandrahmens die Kühlkanalenden 28' nach außen gekrümmt und gerundet ausgeführt, so dass die erwärmte Luft von dem Monitorgehäuse 8 weg geführt wird.

Im unteren Bereich des Gehäuserückwandrahmens 24 ist eine Kabelverbindung 36 durch eine Kabeldurchführung 38 aus dem Inneren des Monitorgehäuses 8 herausgeführt. Die Kabeldurchführung 38 ist durch eine Abdeckung 40 spritzwasserdicht verschließbar ist. Über die Kabeldurchführung 38 können über ein Kabel Bildsignale und Stromversorgung für den Monitor bereitgestellt werden.

Auf der Außenseite des Kühlkörpers 22 sind Schraublöcher 42 vorgesehen, mittels denen der Monitor an seinem Einsatzort, z. B. außen an einem Kraftfahrzeug, befestigt werden kann. Zusätzlich oder alternativ kann die Befestigung des Monitors auch über modifizierte Kühlkanäle 44 mit L-förmigem Querschnitt - links und rechts außen am Kühlkörper 22 - oder über einen modifizierten Kühlkanal 46 mit T-förmigem Querschnitt 46 - in der Mitte des Kühlkörpers - erfolgen. In diese modifizierten Kühlkanälen 44, 46 bzw. Längsnute kann ein entsprechendes Halteelement eingeschoben bzw. eingeführt werden.

### Bezugszeichenliste:

- 2: Funktionsbauteil
- 4: Anzeigepanel
- 6: Ansteuerelektronik
- 8: Monitorgehäuse
- 10: Frontgehäuserahmen
- 12: Gehäuserückwand
- 14: Modulträger
- 16: umlaufende Dichtung
- 18: Bedienelemente
- 20: Sonnenblende
- 22: Kühlkörper
- 24: Gehäuserückwandrahmen
- 26: Kühlrippen
- 26': Stege
- 28: Kühlkanäle
- 28': Kühlkanalenden
- 30: thermische Kontaktfläche
- 32: verformbare Wärme leitende Schicht
- 34: Schrauben
- 36: Kabelverbindung
- 38: Kabeldurchführung
- 40: Abdeckung der Kabeldurchführung
- 42: Schraublöcher
- 44: Kühlkanal mit L-förmigem Querschnitt
- 46: Kühlkanal mit T-förmigem Querschnitt

## Patentansprüche

1. Monitor mit
einem Funktionsbauteil (2), das ein Anzeigepanel (4) und die zugehörige Ansteuerelektronik (6) umfasst,
einem Monitorgehäuse (8) in dem das Funktionsbauteil (2) angeordnet ist, wobei das Monitorgehäuse (8) einen Frontgehäuserahmen (10) und eine Gehäuserückwand (12) umfasst,
wobei das Funktionsbauteil einen Modulträger (14) umfasst, in dem das Anzeigepanel (4) und die Ansteuerelektronik (6) formschlüssig eingefügt sind,
wobei der Modulträger (14) mit Anzeigepanel (4) und Ansteuerelektronik (6) formschlüssig in den Frontgehäuserahmen (10) eingefügt ist,
wobei die Gehäuserückwand (12) mit dem Frontgehäuserahmen (10) verschraubt ist, und
wobei das Anzeigepanel (4) und die Ansteuerelektronik (6) zwischen Frontgehäuserahmen (10) und Gehäuserückwand (12) geklemmt sind, **dadurch gekennzeichnet,**
**dass** in die Gehäuserückwand (12) ein Kühlkörper (22) integriert ist,
**dass** der Kühlkörper (22) ein Teil der Gehäuserückwand (12) ist und von einem Gehäuserückwandrahmen (24) umgeben ist,
**dass** der Gehäuserückwandrahmen (24) aus Kunststoff und der Kühlkörper (22) aus Metall sind,
**dass** der Kühlkörper (22) auf der Monitorgehäuseaußenseite Kühlrippen (26) zur Abgabe von Wärme und auf der Monitorgehäuseinnenseite eine thermische Kontaktfläche (30) zur Aufnahme von Wärme von dem Funktionsbauteil (2) aufweist, und
**dass** der Gehäuserückwandrahmen (24) mittels Spritzguss um den Kühlkörper (22) geformt ist und damit Gehäuserückwandrahmen (24) und Kühlkörper (22) spritzwasserdicht miteinander verbunden sind.

2. Monitor nach Anspruch 1, **dadurch gekennzeichnet, dass** in den Frontgehäuserahmen (10) von außen zugängliche Bedienelemente (18) integriert sind.

3. Monitor nach Anspruch 2, **dadurch gekennzeichnet, dass** die Bedienelemente (18) von vorne in den Frontgehäuserahmen (10) eingefügt sind.

4. Monitor nach Anspruch 2 oder 3, **dadurch gekennzeichnet, dass** die Bedienelemente (18) in dem Frontgehäuserahmen (10) eingeklebt sind, insbesondere mittels einer selbstklebenden Rückseite.

5. Monitor nach einem der vorhergehenden Ansprüche, **dadurch gekennzeichnet, dass** zwischen dem Anzeigepanel (4) und dem Frontgehäuserahmen (10) eine umlaufende Dichtung (16) vorgesehen ist.

6. Monitor nach einem der vorhergehenden Ansprüche, **dadurch gekennzeichnet, dass** das Anzeigepanel (4) von einer Seite in den Modulträger (14) eingefügt ist, und dass die Ansteuerelektronik (6) von der gegenüberliegenden Seite her in den Modulträger (14) eingefügt ist.

7. Monitor nach einem der vorhergehenden Ansprüche, **dadurch gekennzeichnet, dass** das Monitorgehäuse (8) spritzwasserdicht ist.

8. Monitor nach einem der vorhergehenden Ansprüche, **dadurch gekennzeichnet, dass** zwischen dem Funktionsbauteil (2) und der thermischen Kontaktfläche (30) des Kühlkörpers (22) eine verformbare Wärme leitende Schicht (32) angeordnet ist.

9. Monitor nach einem der vorhergehenden Ansprüche, **dadurch gekennzeichnet, dass** zwischen den Kühlrippen (26) Kühlkanäle (28) ausgebildet sind, dass die Kühlrippen (26) durch Stege (26') in den Gehäuserückwandrahmen (24) hinein verlängert sind, und dass die Kühlkanäle (28) durch Kühlkanalenden (28') in den Gehäuserückwandrahmen (24) hinein verlängert sind.

10. Monitor nach einem der vorhergehenden Ansprüche, **dadurch gekennzeichnet**, durch eine Kabelverbindung (36), die im Bereich des Gehäuserückwandrahmens (24) über eine Kabeldurchführung (38) nach außen geführt ist.

11. Monitor nach einem der vorhergehenden Ansprüche, **dadurch gekennzeichnet, dass** der Kühlkörper (22) an der Monitorgehäuseaußenseite Mittel (42, 44, 46) zur Befestigung des Monitors an einem Einsatzort aufweist.

12. Monitor nach Anspruch 11, **dadurch gekennzeichnet, dass** die Mittel zur Befestigung des Monitors am Einsatzort Schraublöcher (42) umfassen.

13. Monitor nach Anspruch 11 oder 12, **dadurch gekennzeichnet, dass** die Mittel zur Befestigung des Monitors am Einsatzort wenigstens eine Längsnut (46) mit T-förmigem Querschnitt umfassen.

14. Monitor nach einem der vorhergehenden Ansprüche, **dadurch gekennzeichnet, dass** die Mittel zur Befestigung des Monitors am Einsatzort wenigstens eine Längsnut (44) mit L-förmigem Querschnitt umfassen.

15. Gehäuserückwand für einen Monitor nach einem der vorhergehenden Ansprüche, **dadurch gekennzeichnet,**
**dass** in die Gehäuserückwand (12) ein Kühlkörper (22) integriert ist,
**dass** der Kühlkörper (22) einen Teil der Gehäuserückwand (12) bildet und von einem Gehäuserückwandrahmen (24) umgeben ist, und
**dass** der Kühlkörper (22) auf der Monitorgehäuseaußenseite Kühlrippen (26) zur Abgabe von Wärme und auf der Monitorgehäuseinnenseite eine thermische Kontaktfläche (30) zur Aufnahme von Wärme von dem Funktionsbauteil (2) aufweist, und
**dass** der Gehäuserückwandrahmen (24) aus Kunststoff und der Kühlkörper (22) aus Metall sind, und
**dass** der Gehäuserückwandrahmen mittels Spritzguss um den Kühlkörper geformt ist und damit Gehäuserückwandrahmen und Kühlkörper spritzwasserdicht miteinander verbunden sind.

16. Gehäuserückwand nach Anspruch 15, **dadurch gekennzeichnet, dass** zwischen den Kühlrippen (26) Kühlkanäle (28) ausgebildet sind, dass die Kühlrippen (26) durch Stege (26') in den Gehäuserückwandrahmen (24) hinein verlängert sind, und dass die Kühlkanäle (28) durch Kühlkanalenden (28') in den Gehäuserückwandrahmen (24) hinein verlängert sind.

17. Gehäuserückwand nach Anspruch 15 oder 16, **dadurch gekennzeichnet, dass** der Kühlkörper (22) an der Monitorgehäuseaußenseite Mittel (42, 44, 46) zur Befestigung des Monitors an einem Einsatzort aufweist.

18. Gehäuserückwand nach Anspruch 17, **dadurch gekennzeichnet, dass** die Mittel zur Befestigung des Monitors am Einsatzort Schraublöcher (42) umfassen.

19. Gehäuserückwand nach Anspruch 17 oder 18, **dadurch gekennzeichnet, dass** die Mittel zur Befestigung des Monitors am Einsatzort wenigstens eine Längsnut (46) mit T-förmigem Querschnitt umfassen.

20. Gehäuserückwand nach einem der vorhergehenden Ansprüche 17 bis 19, **dadurch gekennzeichnet, dass** die Mittel zur Befestigung des Monitors am Einsatzort wenigstens eine Längsnut (44) mit L-förmigem Querschnitt umfassen.

## Claims

1. A monitor comprising:
a functional component (2) including a display panel (4) and corresponding control electronics (6),
a monitor housing (8), wherein the functional component (2) is arranged,
wherein the monitor housing (8) includes a front housing frame (10) and a rear housing panel (12),
wherein the functional component includes a module support (14), wherein the display panel (4) and the control electronics (6) are form-fit inserted,
wherein the module support (10) including the display panel (4) and the control electronics (6) is form-fit inserted into the front housing frame (10),
wherein the rear housing panel (12) and the front housing frame (10) are screwed together, and
wherein the display panel (4) and the control electronics (6) are clamped in place between the front housing frame (10) and the rear housing panel (12),
**characterized in that**
a cooling element (22) is integrated into the rear housing panel (12),
the cooling element (22) is a part of the rear housing panel (12) and surrounded by a rear housing panel frame (24),
the rear housing panel frame (24) is made of plastic and the cooling element (22) is made of metal,
the cooling element (22) comprises cooling fins (26) for heat dissipation on the monitor housing exterior and a thermal contact surface (30) for absorbing heat emitted from the functional component (2) on the monitor housing interior, and
the rear housing panel frame (24) is molded around the cooling element (22) such that water cannot penetrate between the rear housing panel frame (24) and the cooling element (22).

2. Monitor according to claim 1, **characterized in that** control elements (18) are integrated into the front housing frame (10), wherein the control elements are accessible from outside the monitor.

3. Monitor according to claim 2, **characterized in that** the control elements (18) are inserted from the front side of the front housing frame (10).

4. Monitor according to claim 2 or 3, **characterized in that** the control elements (18) are glued to the front housing frame (10) using an adhesive layer on the back side of the control elements (18).

5. Monitor according to any one of the preceding claims, **characterized in that** a peripheral seal (16) is disposed between the display panel (4) and the front housing frame (10).

6. Monitor according to any one of the preceding claims, **characterized in that** the display panel (4) is inserted into the module support (14) from one side and the control electronics (6) are inserted into the module support (14) from the opposite side.

7. Monitor according to any one of the preceding claims, **characterized in that** the monitor housing (8) is impermeable to water spray.

8. Monitor according to any one of the preceding claims, **characterized in that** a deformable heat conducting layer (32) is sandwiched between the functional component (2) and the thermal contact surface (30) of the cooling element (22).

9. Monitor according to any one of the preceding claims, **characterized in that** cooling ducts (28) are formed between the cooling fins (26), wherein fin extensions (26') extend the cooling fins (26) into the rear housing panel frame (24), and wherein cooling duct ends extend the cooling ducts (28) into the rear housing panel frame (24).

10. Monitor according to any one of the preceding claims, **characterized in that** a cable connection (36) is routed outwards in an area of the rear housing panel frame (24) via a cable bushing (38).

11. Monitor according to any one of the preceding claims, **characterized in that** the cooling element (22) includes means (42, 44, 46) on the monitor housing exterior for mounting the monitor at a place of use.

12. Monitor according to claim 11, **characterized in that** the means for mounting the monitor at the place of use include screw holes (42).

13. Monitor according to claim 11 or 12, **characterized in that** the means for mounting the monitor at the place of use include at least one longitudinal slot (46) that has a T-shaped cross section.

14. Monitor according to any one of the preceding claims, **characterized in that** the means for mounting the monitor at the place of use include at least one longitudinal slot (44) that has a L-shaped cross section.

15. Rear housing panel for a monitor according to any one of the preceding claims, **characterized in that**
a cooling element (22) is integrated in the rear housing panel (12),
the cooling element (22) forms a part of the rear housing panel (12) and is surrounded by a rear housing panel frame (24), and
the cooling element (22) comprises cooling fins (26) for heat dissipation on the monitor housing exterior and a thermal contact surface (30) for absorbing heat emitted from the functional component (2) on the monitor housing interior, and
the rear housing panel frame (24) is made of plastic and the cooling element (22) is made of metal, and
the rear housing panel frame is molded around the cooling element such that water cannot penetrate between the rear housing panel frame and the cooling element.

16. Rear housing panel according to claim 15, **characterized in that** cooling ducts (28) are formed between the cooling fins (26), wherein fin extensions (26') extend the cooling fins (26) into the rear housing panel frame (24), and wherein cooling duct ends (28') extend the cooling ducts (28) into the rear housing panel frame (24).

17. Rear housing panel according to claim 15 or 16, **characterized in that** the cooling element (22) includes means (42, 44, 46) on the monitor housing exterior for mounting the monitor at a place of use.

18. Rear housing panel according to claim 17, **characterized in that** the means for mounting the monitor at the place of use include screw holes (42).

19. Rear housing panel according to claim 17 or 18, **characterized in that** the means for mounting the monitor at the place of use include at least one longitudinal slot (46) that has a T-shaped cross section.

20. Rear housing panel according to one of the preceding claims 17 to 19, **characterized in that** the means for mounting the monitor at the place of use include at least one longitudinal slot (44) that has a L-shaped cross section.

## Revendications

1. Moniteur comprenant
un composant fonctionnel (2), qui comporte un panneau d'affichage (4) et l'électronique de commande (6) associée,
un logement de moniteur (8) dans lequel est agencé le composant fonctionnel (2),
le logement de moniteur (8) comportant un cadre de logement avant (10) et une paroi arrière de logement (12),
le composant fonctionnel comportant un support de module (14), dans lequel le panneau d'affichage (4) et l'électronique de commande (6) sont insérés par coopération de formes,
le support de module (14) comprenant le panneau d'affichage (4) et l'électronique de commande (6) étant inséré par coopération de formes dans le cadre de logement avant (10),
la paroi arrière de logement (12) étant vissée au cadre de logement avant (10), et
le panneau d'affichage (4) et l'électronique de commande (6) étant serrés entre le cadre de logement avant (10) et la paroi arrière de logement (12),
**caractérisé**
**en ce qu'**un corps de refroidissement (22) est intégré dans la paroi arrière de logement (12),
**en ce que** le corps de refroidissement (22) fait partie de la paroi arrière de logement (12) et est entouré par un cadre de paroi arrière de logement (24),
**en ce que** le cadre de paroi arrière de logement (24) est fait de matière plastique et le corps de refroidissement (22) de métal,
**en ce que** le corps de refroidissement (22) présente sur la face extérieure du logement de moniteur des nervures de refroidissement (26) pour le dégagement de chaleur et, sur la face intérieure du logement de moniteur, une surface de contact thermique (30) pour l'absorption de chaleur du composant fonctionnel (2), et
**en ce que** le cadre de paroi arrière de logement (24) est moulé par injection autour du corps de refroidissement (22) et par voie de conséquence, le cadre de paroi arrière de logement (24) et le corps de refroidissement (22) sont reliés l'un à l'autre de manière étanche aux éclaboussures d'eau.

2. Moniteur selon la revendication 1, **caractérisé en ce que** des éléments de commande (18) accessibles de l'extérieur sont intégrés dans le cadre de logement avant (10).

3. Moniteur selon la revendication 2, **caractérisé en ce que** les éléments de commande (18) sont insérés par l'avant dans le cadre de logement avant (10).

4. Moniteur selon la revendication 2 ou 3, **caractérisé en ce que** les éléments de commande (18) sont collés dans le cadre de logement avant (10), en particulier au moyen d'une face arrière auto-adhésive.

5. Moniteur selon l'une quelconque des revendications précédentes, **caractérisé en ce qu'**un joint périphérique (16) est prévu entre le panneau d'affichage (4) et le cadre de logement avant (10) .

6. Moniteur selon l'une quelconque des revendications précédentes, **caractérisé en ce que** le panneau d'affichage (4) est inséré par un côté dans le support de module (14), et **en ce que** l'électronique de commande (6) est insérée par le côté opposé dans le support de module (14).

7. Moniteur selon l'une quelconque des revendications précédentes, **caractérisé en ce que** le logement de moniteur (8) est étanche aux éclaboussures d'eau.

8. Moniteur selon l'une quelconque des revendications précédentes, **caractérisé en ce qu'**une couche thermo-conductrice (32) déformable est agencée entre le composant fonctionnel (2) et la surface de contact thermique (30) du corps de refroidissement (22).

9. Moniteur selon l'une quelconque des revendications précédentes, **caractérisé en ce que** des canaux de refroidissement (28) sont formés entre les nervures de refroidissement (26), **en ce que** les nervures de refroidissement (26) se prolongent à l'intérieur du cadre de paroi arrière de logement (24) par l'intermédiaire d'éléments de liaison (26'), et **en ce que** les canaux de refroidissement (28) se prolongent à l'intérieur du cadre de paroi arrière de logement (24) par l'intermédiaire d'extrémités de canal de refroidissement (28').

10. Moniteur selon l'une quelconque des revendications précédentes, **caractérisé par** une liaison par câble (36) qui est guidée vers l'extérieur par l'intermédiaire d'un passage de câble (38) dans la zone du cadre de paroi arrière de logement (24).

11. Moniteur selon l'une quelconque des revendications précédentes, **caractérisé en ce que** le corps de refroidissement (22) présente sur la face extérieure du logement de moniteur des moyens (42, 44, 46) destinés à fixer le moniteur en un lieu d'utilisation.

12. Moniteur selon la revendication 11, **caractérisé en ce que** les moyens destinés à fixer le moniteur au lieu d'utilisation comportent des trous pour vis (42).

13. Moniteur selon la revendication 11 ou 12, **caractérisé en ce que** les moyens destinés à fixer le moniteur au lieu d'utilisation comportent au moins une rainure longitudinale (46) présentant une section transversale en forme de T.

14. Moniteur selon l'une quelconque des revendications précédentes, **caractérisé en ce que** les moyens destinés à fixer le moniteur au lieu d'utilisation comportent au moins une rainure longitudinale (44) présentant une section transversale en forme de L.

15. Paroi arrière de logement pour un moniteur selon l'une quelconque des revendications précédentes, **caractérisée en ce qu'**un corps de refroidissement (22) est intégré dans la paroi arrière de logement (12),
**en ce que** le corps de refroidissement (22) forme une partie de la paroi arrière de logement (12) et est entouré par un cadre de paroi arrière de logement (24), et
**en ce que** le corps de refroidissement (22) présente sur la face extérieure de logement de moniteur des nervures de refroidissement (26) pour l'émission de chaleur et sur la face intérieure du logement de moniteur une surface de contact thermique (30) pour l'absorption de chaleur du composant fonctionnel (2), et
**en ce que** le cadre de paroi arrière de logement (24) est fait de matière plastique et le corps de refroidissement (22) de métal, et
**en ce que** le cadre de paroi arrière de logement est moulé par injection autour du corps de refroidissement et par voie de conséquence, le cadre de paroi arrière de logement et le corps de refroidissement sont reliés l'un à l'autre de manière étanche aux éclaboussures d'eau.

16. Paroi arrière de logement selon la revendication 15, **caractérisée en ce que** des canaux de refroidissement (28) sont formés entre les nervures de refroidissement (26), **en ce que** les nervures de refroidissement (26) se prolongent à l'intérieur du cadre de paroi arrière de logement (24) par l'intermédiaire d'éléments de liaison (26'), et **en ce que** les canaux de refroidissement (28) se prolongent à l'intérieur du cadre de paroi arrière de logement (24) par l'intermédiaire d'extrémités de canal de refroidissement (28').

17. Paroi arrière de logement selon la revendication 15 ou 16, **caractérisée en ce que** le corps de refroidissement (22) présente sur la face extérieure du logement de moniteur des moyens (42, 44, 46) destinés à fixer le moniteur en un lieu d'utilisation.

18. Paroi arrière de logement selon la revendication 17, **caractérisée en ce que** les moyens destinés à fixer le moniteur au lieu d'utilisation comportent des trous pour vis (42).

19. Paroi arrière de logement selon la revendication 17 ou 18, **caractérisée en ce que** les moyens destinés à fixer le moniteur au lieu d'utilisation comportent au moins une rainure longitudinale (46) présentant une section transversale en forme de T.

20. Paroi arrière de logement selon l'une quelconque des revendications 17 à 19, **caractérisée en ce que** les moyens destinés à fixer le moniteur au lieu d'utilisation comportent au moins une rainure longitudinale (44) présentant une section transversale en forme de L.
